# EUROPEAN PATENT APPLICATION

(11) **EP 4 679 148 A1**
(43) Date of publication of application: **14.01.2026**
(21) Application number: 24770578.3
(22) Date of filing: 01.03.2024
(51) Int. Cl.: G02B 5/30, B32B 7/12, B32B 7/023, G02B 3/00, G02B 27/02

(54) **LENS PART, DISPLAY BODY, AND DISPLAY METHOD**

(30) Priority: 10.03.2023 JP 2023037520
(71) Applicant: Nitto Denko Corporation, Ibaraki-shi, Osaka 567-8680 (JP)
(72) Inventor: NAMBARA, Takuya, Ibaraki-shi, Osaka 567-8680 (JP); GOTO, Shusaku, Ibaraki-shi, Osaka 567-8680 (JP)
(74) Representative: Hoffmann Eitle
(86) International application number: PCT/JP2024/007811
(87) International publication number: WO 2024/190467

(57) **Abstract**

Provided is a lens unit that can achieve a reduction in weight of a pair of VR goggles and an improvement in viewability thereof. The lens unit according to an embodiment of the present invention is a lens unit to be used in a display system configured to display an image to a user, the lens unit including: a reflection-type polarizing member configured to reflect light, which has been emitted to a front side from a display surface of a display element configured to display the image, and has passed through a polarizing member and a first λ/4 member; a first lens portion arranged on an optical path between the display element and the reflection-type polarizing member; a half mirror arranged between the display element and the first lens portion, the half mirror being configured to transmit the light emitted from the display element and to reflect the light reflected by the reflection-type polarizing member toward the reflection-type polarizing member; a second lens portion arranged on the front side of the reflection-type polarizing member; and a retardation member arranged on an optical path between the half mirror and the reflection-type polarizing member, wherein the retardation member includes a first retardation layer, an adhesion layer, and a second retardation layer in the stated order, the first retardation layer or the second retardation layer functions as a second λ/4 member, and a refractive index n₁ of the first retardation layer at a wavelength of 550 nm, a refractive index n₀ of the adhesion layer at a wavelength of 550 nm, and a refractive index n₂ of the second retardation layer at a wavelength of 550 nm satisfy relationships represented by the following formulae (1) and (2). ${n}_{1} \leq {n}_{0} \leq {n}_{2}$ ${n}_{2} - {n}_{1} < 0.13$

## Description

### Technical Field

The present invention relates to a lens unit, a display body, and a display method.

### Background Art

Image display apparatus typified by a liquid crystal display apparatus and an electroluminescence (EL) display apparatus (e.g., an organic EL display apparatus) have been rapidly gaining more widespread use. In the image display apparatus, an optical member, such as a polarizing member or a retardation member, has been generally used for achieving image display and improving the performance of the image display (see, for example, Patent Literature 1).

In recent years, new applications of the image display apparatus have been developed. For example, a pair of goggles (VR goggles) with a display for achieving virtual reality (VR) has started to be commercialized. A reduction in weight of the pair of VR goggles, an improvement in viewability thereof, and the like have been desired because an investigation has been made on the utilization of the pair of VR goggles in various fields. The weight reduction may be achieved by, for example, thinning a lens to be used in the pair of VR goggles. Meanwhile, the development of an optical member suitable for a display system using a thin lens has also been desired.

### Citation List

### Patent Literature

[PTL 1] JP 2021-103286 A

### Summary of Invention

### Technical Problem

In view of the foregoing, a primary object of the present invention is to provide a lens unit that can achieve a reduction in weight of a pair of VR goggles and an improvement in viewability thereof.

### Solution to Problem

1. According to an embodiment of the present invention, there is provided a lens unit to be used in a display system configured to display an image to a user, the lens unit including: a reflection-type polarizing member configured to reflect light, which has been emitted to a front side from a display surface of a display element configured to display the image, and has passed through a polarizing member and a first λ/4 member; a first lens portion arranged on an optical path between the display element and the reflection-type polarizing member; a half mirror arranged between the display element and the first lens portion, the half mirror being configured to transmit the light emitted from the display element and to reflect the light reflected by the reflection-type polarizing member toward the reflection-type polarizing member; a second lens portion arranged on the front side of the reflection-type polarizing member; and a retardation member arranged on an optical path between the half mirror and the reflection-type polarizing member, wherein the retardation member includes a first retardation layer, an adhesion layer, and a second retardation layer in the stated order, the first retardation layer or the second retardation layer functions as a second λ/4 member, and a refractive index n₁ of the first retardation layer at a wavelength of 550 nm, a refractive index n₀ of the adhesion layer at a wavelength of 550 nm, and a refractive index n₂ of the second retardation layer at a wavelength of 550 nm satisfy relationships represented by the following formulae (1) and (2). ${n}_{1} \leq {n}_{0} \leq {n}_{2}$ ${n}_{2} - {n}_{1} < 0.13$
2. In the lens unit according to the above-mentioned item 1, the refractive index n₂ of the second retardation layer at a wavelength of 550 nm may satisfy the following formula (3). $1.40 < {n}_{2} < 1.70$
3. In the lens unit according to the above-mentioned item 1 or 2, the second λ/4 member may satisfy Re(450)<Re(550).
4. The lens unit according to any one of the above-mentioned items 1 to 3 may include a laminate portion including the retardation member.
5. In the lens unit according to the above-mentioned item 4, the laminate portion may include the reflection-type polarizing member.
6. In the lens unit according to the above-mentioned item 5, the laminate portion may include an absorption-type polarizing member arranged between the reflection-type polarizing member and the second lens portion.
7. In the lens unit according to the above-mentioned item 5 or 6, the laminate portion may include a third λ/4 member arranged between the reflection-type polarizing member and the second lens portion.
8. In the lens unit according to any one of the above-mentioned items 4 to 7, the laminate portion may include a protective member arranged on a front side of the retardation member.
9. According to an embodiment of the present invention, there is provided a display body, including the lens unit of any one of the above-mentioned items 1 to 8.
10. According to an embodiment of the present invention, there is provided a display method, including the steps of: passing light representing an image, which has been emitted through a polarizing member and a first λ/4 member, through a half mirror and a first lens portion; passing the light, which has passed through the half mirror and the first lens portion, through a retardation member; reflecting the light, which has passed through the retardation member, toward the half mirror with a reflection-type polarizing member; enabling the light, which has been reflected by the reflection-type polarizing member and the half mirror, to penetrate through the reflection-type polarizing member with the retardation member; and passing the light, which has penetrated through the reflection-type polarizing member, through a second lens portion, wherein the retardation member includes a first retardation layer, an adhesion layer, and a second retardation layer in the stated order, the first retardation layer or the second retardation layer functions as a second λ/4 member, and a refractive index n₁ of the first retardation layer at a wavelength of 550 nm, a refractive index n₀ of the adhesion layer at a wavelength of 550 nm, and a refractive index n₂ of the second retardation layer at a wavelength of 550 nm satisfy relationships represented by the following formulae (1) and (2). ${n}_{1} \leq {n}_{0} \leq {n}_{2}$ ${n}_{2} - {n}_{1} < 0.13$

### Advantageous Effects of Invention

According to the lens unit of the embodiment of the present invention, the reduction in weight of the pair of VR goggles and the improvement in viewability thereof can be achieved.

### Brief Description of Drawings

FIG. **1** is a schematic view for illustrating the schematic configuration of a display system according to one embodiment of the present invention.
FIG. **2** is a schematic sectional view for illustrating an example of the details of the lens unit of the display system illustrated in FIG. **1****.**
FIG. **3** is a schematic perspective view for illustrating an example of a multilayer structure in a reflection-type polarizing film.
FIG. **4** is a schematic sectional view for illustrating another example of the details of the lens unit of the display system illustrated in FIG. **1****.**
FIG. **5** is a view for describing a method of measuring a transmittance.

### Description of Embodiments

Embodiments of the present invention are described below with reference to the drawings. However, the present invention is not limited to these embodiments. For clearer illustration, some widths, thicknesses, shapes, and the like of respective portions may be schematically illustrated in the drawings in comparison to the embodiments. However, the widths, the thicknesses, the shapes, and the like are each merely an example, and do not limit the understanding of the present invention. In addition, in the drawings, the same components or equivalent components may be denoted by the same reference symbols, and duplicate descriptions thereof may be omitted.

### (Definitions of Terms and Symbols)

The definitions of terms and symbols used herein are as described below.

### (1) Refractive Indices (nx, ny, and nz)

"nx" represents a refractive index in a direction in which an in-plane refractive index is maximum (that is, slow axis direction), "ny" represents a refractive index in a direction perpendicular to a slow axis in a plane (that is, fast axis direction), and "nz" represents a refractive index in a thickness direction.

### (2) In-plane Retardation (Re)

"Re(λ)" refers to an in-plane retardation measured at 23°C with light having a wavelength of λ nm. For example, "Re(550)" refers to an in-plane retardation measured at 23°C with light having a wavelength of 550 nm. The Re(λ) is determined from the equation "Re(λ)=(nx-ny)×d" when the thickness of a layer (film) is represented by "d" (nm).

### (3) Thickness Direction Retardation (Rth)

"Rth(λ)" refers to a thickness direction retardation measured at 23°C with light having a wavelength of λ nm. For example, "Rth(550)" refers to a thickness direction retardation measured at 23°C with light having a wavelength of 550 nm. The Rth(λ) is determined from the equation "Rth(λ)=(nx-nz)×d" when the thickness of a layer (film) is represented by "d" (nm).

### (4) Nz Coefficient

An Nz coefficient is determined from the equation "Nz=Rth/Re".

### (5) Angle

When reference is made to an angle herein, the angle encompasses both angles in a clockwise direction and a counterclockwise direction with respect to a reference direction. Accordingly, for example, the term "45°" means ±45°.

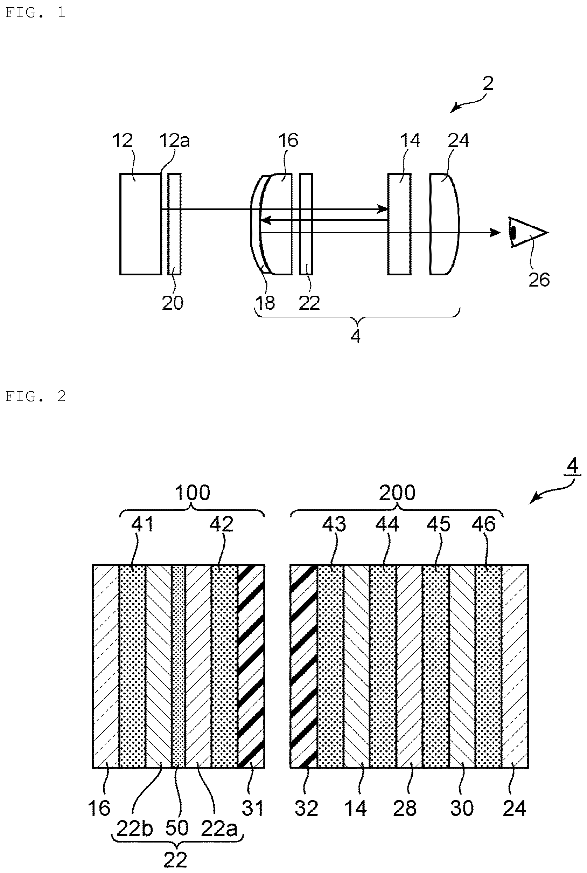

FIG. **1** is a schematic view for illustrating the schematic configuration of a display system according to one embodiment of the present invention. The arrangement, shapes, and the like of the respective constituents of a display system **2** are schematically illustrated in FIG. **1****.** The display system **2** includes: a display element **12;** a reflection-type polarizing member **14;** a first lens portion **16;** a half mirror **18;** a first retardation member **20;** a second retardation member **22;** and a second lens portion **24.** The reflection-type polarizing member **14** is arranged on the front side of the display element **12,** that is, on the display surface **12a** side thereof, and can reflect light emitted from the display element **12.** The first lens portion **16** is arranged on an optical path between the display element **12** and the reflection-type polarizing member **14,** and the half mirror **18** is arranged between the display element **12** and the first lens portion **16.** The first retardation member **20** is arranged on an optical path between the display element **12** and the half mirror **18,** and the second retardation member **22** is arranged on an optical path between the half mirror **18** and the reflection-type polarizing member **14.**

The half mirror and the constituents arranged on the front side thereof (in the illustrated example, the half mirror **18,** the first lens portion **16,** the second retardation member **22,** the reflection-type polarizing member **14,** and the second lens portion **24)** are sometimes collectively referred to as "lens unit (lens unit **4)."**

The display element **12** is, for example, a liquid crystal display or an organic EL display, and has a display surface **12a** for displaying an image. The light to be emitted from the display surface **12a** passes through, for example, a polarizing member (typically, a polarizing film) that may be incorporated into the display element **12** to be emitted as first linearly polarized light.

The first retardation member **20** includes a first A/4 member that can convert the first linearly polarized light, which has entered the first retardation member **20,** into first circularly polarized light. When the first retardation member is free of any member other than the first λ/4 member, the first retardation member may correspond to the first λ/4 member. The first retardation member **20** may be arranged integrally with the display element **12.**

The half mirror **18** transmits the light emitted from the display element **12,** and reflects the light reflected by the reflection-type polarizing member **14** toward the reflection-type polarizing member **14.** The half mirror **18** is arranged integrally with the first lens portion **16.**

The second retardation member **22** includes a second A/4 member that can cause the light, which has been reflected by the reflection-type polarizing member **14** and the half mirror **18,** to penetrate through the reflection-type polarizing member **14.** When the second retardation member is free of any member other than the second λ/4 member, the second retardation member may correspond to the second λ/4 member. The second retardation member **22** may be arranged integrally with the first lens portion **16.**

The first circularly polarized light emitted from the first λ/4 member in the first retardation member **20** passes through the half mirror **18** and the first lens portion **16,** and is converted into second linearly polarized light by the second λ/4 member in the second retardation member **22.** The second linearly polarized light emitted from the second λ/4 member is reflected toward the half mirror **18** without penetrating through the reflection-type polarizing member **14.** At this time, the polarization direction of the second linearly polarized light that has entered the reflection-type polarizing member **14** is the same direction as that of the reflection axis of the reflection-type polarizing member **14.** Accordingly, the second linearly polarized light that has entered the reflection-type polarizing member **14** is reflected by the reflection-type polarizing member **14.**

The second linearly polarized light reflected by the reflection-type polarizing member **14** is converted into second circularly polarized light by the second λ/4 member in the second retardation member **22,** and the second circularly polarized light emitted from the second λ/4 member passes through the first lens portion **16,** and is reflected by the half mirror **18.** The second circularly polarized light reflected by the half mirror **18** passes through the first lens portion **16,** and is converted into third linearly polarized light by the second λ/4 member in the second retardation member **22.** The third linearly polarized light penetrates through the reflection-type polarizing member **14.** At this time, the polarization direction of the third linearly polarized light that has entered the reflection-type polarizing member **14** is the same direction as that of the transmission axis of the reflection-type polarizing member **14.** Accordingly, the third linearly polarized light that has entered the reflection-type polarizing member **14** penetrates through the reflection-type polarizing member **14.**

The light that has penetrated through the reflection-type polarizing member **14** passes through the second lens portion **24** to enter an eye **26** of a user.

For example, the absorption axis of the polarizing member in the display element **12** and the reflection axis of the reflection-type polarizing member **14** may be arranged substantially parallel to each other, or may be arranged substantially perpendicular to each other. An angle formed by the absorption axis of the polarizing member in the display element **12** and the slow axis of the first λ/4 member in the first retardation member **20** is, for example, from 40° to 50°, and may be from 42° to 48°, or may be about 45°. An angle formed by the absorption axis of the polarizing member in the display element **12** and the slow axis of the second λ/4 member in the second retardation member **22** is, for example, from 40° to 50°, and may be from 42° to 48°, or may be about 45°.

The in-plane retardation Re(550) of the first λ/4 member is, for example, from 100 nm to 190 nm, and may be from 110 nm to 180 nm, may be from 130 nm to 160 nm, or may be from 135 nm to 155 nm. The first λ/4 member preferably shows such a reverse wavelength dispersion characteristic that its retardation value increases with an increase in wavelength of measurement light. The ratio "Re(450)/Re(550)" of the first λ/4 member is, for example, 0.75 or more and less than 1, and may be 0.8 or more and 0.95 or less.

The in-plane retardation Re(550) of the second λ/4 member is, for example, from 100 nm to 190 nm, and may be from 110 nm to 180 nm, may be from 130 nm to 160 nm, or may be from 135 nm to 155 nm. The second λ/4 member preferably shows such a reverse wavelength dispersion characteristic that its retardation value increases with an increase in wavelength of measurement light. The ratio "Re(450)/Re(550)" of the second λ/4 member is, for example, 0.75 or more and less than 1, and may be 0.8 or more and 0.95 or less.

In the lens unit **4,** a space may be formed between the first lens portion **16** and the second lens portion **24.** In this case, a member to be arranged between the first lens portion **16** and the second lens portion **24** is preferably arranged integrally with one of the first lens portion **16** or the second lens portion **24.** For example, the member to be arranged between the first lens portion **16** and the second lens portion **24** is preferably integrated with one of the first lens portion **16** or the second lens portion **24** via an adhesion layer. According to such form, for example, the handleability of each member can be excellent. The adhesion layer may be formed of an adhesive, or may be formed of a pressure-sensitive adhesive. Specifically, the adhesion layer may be an adhesive layer or a pressure-sensitive adhesive layer. The thickness of the adhesion layer is, for example, from 0.05 µm to 30 µm.

FIG. **2** is a schematic sectional view for illustrating an example of the details of the lens unit of the display system illustrated in FIG. **1****.** Specifically, FIG. **2** is an illustration of a first lens portion, a second lens portion, and members to be arranged therebetween. The lens unit **4** includes the first lens portion **16,** a first laminate portion **100** arranged adjacent to the first lens portion **16,** the second lens portion **24,** and a second laminate portion **200** arranged adjacent to the second lens portion **24.** In the example illustrated in FIG. **2****,** the first laminate portion **100** and the second laminate portion **200** are arranged so as to be spaced apart from each other. A half mirror may be arranged integrally with the first lens portion **16,** though the half mirror is not shown.

The first laminate portion **100** includes: the second retardation member **22;** and an adhesion layer (e.g., a pressure-sensitive adhesive layer) **41** arranged between the first lens portion **16** and the second retardation member **22,** and is arranged integrally with the first lens portion **16** via the adhesion layer **41.** The first laminate portion **100** further includes a first protective member **31** arranged on the front side of the second retardation member **22.** The first protective member **31** is laminated on the second retardation member **22** via an adhesion layer (e.g., a pressure-sensitive adhesive layer) **42,** and is arranged adjacent to the second retardation member **22.** The first protective member **31** may be positioned on the outermost surface of the first laminate portion **100.** The phrase "adjacent to" as used herein encompasses not only a case in which the constituents are directly next to each other but also a case in which the constituents are next to each other via an adhesion layer.

In the example illustrated in FIG. **2****,** the second retardation member **22** includes another retardation layer **22b** in addition to a second λ/4 member **22a.** The second retardation member **22** has a laminated structure of the second λ/4 member **22a** and the another retardation layer **22b.** For example, a member (so-called positive C-plate) whose refractive index characteristic may show the relationship of nz>nx=ny is used as the another retardation layer **22b.** In this case, as illustrated in FIG. **2****,** in the second retardation member **22,** the second λ/4 member **22a** is preferably positioned on the front side of the positive C-plate **22b.**

The refractive index characteristic of the above-mentioned second λ/4 member preferably shows the relationship of nx>ny≥nz. The equation "ny=nz" as used herein encompasses not only a case in which the ny and the nz are completely equal to each other but also a case in which the ny and the nz are substantially equal to each other. Accordingly, there may occur a case in which the ny is smaller than the nz to the extent that the effects of the present invention are not impaired. The Nz coefficient of the second λ/4 member is preferably from 0.9 to 3, more preferably from 0.9 to 2.5, still more preferably from 0.9 to 1.5, particularly preferably from 0.9 to 1.3.

The second λ/4 member is formed of any appropriate material that may satisfy the above-mentioned characteristics. The second λ/4 member may be, for example, a stretched film of a resin film or an alignment fixed layer of a liquid crystal compound.

A resin to be incorporated into the above-mentioned resin film is, for example, a polycarbonate-based resin, a polyester carbonate-based resin, a polyester-based resin, a polyvinyl acetal-based resin, a polyarylate-based resin, a cyclic olefin-based resin, a cellulose-based resin, a polyvinyl alcohol-based resin, a polyamide-based resin, a polyimide-based resin, a polyether-based resin, a polystyrene-based resin, or an acrylic resin. Those resins may be used alone or in combination thereof. A method for the combination is, for example, blending or copolymerization. When the second λ/4 member shows a reverse wavelength dispersion characteristic, a resin film containing a polycarbonate-based resin or a polyester carbonate-based resin (hereinafter sometimes simply referred to as "polycarbonate-based resin") may be suitably used.

Any appropriate polycarbonate-based resin may be used as the above-mentioned polycarbonate-based resin. For example, the polycarbonate-based resin includes a structural unit derived from a fluorene-based dihydroxy compound, a structural unit derived from an isosorbide-based dihydroxy compound, and a structural unit derived from at least one dihydroxy compound selected from the group consisting of: an alicyclic diol; an alicyclic dimethanol; di-, tri-, or polyethylene glycol; and an alkylene glycol or spiroglycol. The polycarbonate-based resin preferably includes a structural unit derived from a fluorene-based dihydroxy compound, a structural unit derived from an isosorbide-based dihydroxy compound, and a structural unit derived from an alicyclic dimethanol and/or a structural unit derived from di-, tri-, or polyethylene glycol, and more preferably includes a structural unit derived from a fluorene-based dihydroxy compound, a structural unit derived from an isosorbide-based dihydroxy compound, and a structural unit derived from di-, tri-, or polyethylene glycol. The polycarbonate-based resin may include a structural unit derived from any other dihydroxy compound as required. The details of the polycarbonate-based resin that may be suitably used in the second λ/4 member and a method of forming the second λ/4 member are described in, for example, JP 2014-10291 A, JP 2014-26266 A, JP 2015-212816 A, JP 2015-212817 A, and JP 2015-212818 A, the descriptions of which are incorporated herein by reference.

The thickness of the second λ/4 member including the stretched film of the resin film is, for example, from 10 µm to 100 µm, preferably from 10 µm to 70 µm, more preferably from 20 µm to 60 µm.

The above-mentioned alignment fixed layer of the liquid crystal compound is such a layer that the liquid crystal compound is aligned in a predetermined direction in the layer, and its alignment state is fixed. The term "alignment fixed layer" is a concept encompassing an alignment cured layer obtained by curing a liquid crystal monomer as described later. In the second λ/4 member, the molecules of a rod-shaped liquid crystal compound are typically aligned under the state of being lined up in the slow axis direction of the second λ/4 member (homogeneous alignment). Examples of the rod-shaped liquid crystal compound include a liquid crystal polymer and a liquid crystal monomer. The liquid crystal compound is preferably polymerizable. When the liquid crystal compound is polymerizable, the alignment state of the liquid crystal compound can be fixed by aligning the liquid crystal compound and then polymerizing the compound.

The above-mentioned alignment fixed layer of the liquid crystal compound (liquid crystal alignment fixed layer) may be formed by: subjecting the surface of a predetermined substrate to alignment treatment; applying an application liquid containing a liquid crystal compound to the surface; aligning the liquid crystal compound in a direction corresponding to the above-mentioned alignment treatment; and fixing the alignment state. Any appropriate alignment treatment may be adopted as the alignment treatment. Specific examples thereof include mechanical alignment treatment, physical alignment treatment, and chemical alignment treatment. Specific examples of the mechanical alignment treatment include rubbing treatment and stretching treatment. Specific examples of the physical alignment treatment include magnetic field alignment treatment and electric field alignment treatment. Specific examples of the chemical alignment treatment include an oblique deposition method and photoalignment treatment. Any appropriate conditions may be adopted as treatment conditions for the various alignment treatments in accordance with purposes.

The alignment of the liquid crystal compound is performed through treatment at a temperature at which the liquid crystal compound shows a liquid crystal phase depending on the kind of the liquid crystal compound. When the treatment at such temperature is performed, the liquid crystal compound adopts a liquid crystal state, and the liquid crystal compound is aligned in accordance with the alignment treatment direction of the surface of the substrate.

In one embodiment, the fixation of the alignment state is performed by cooling the liquid crystal compound aligned as described above. When the liquid crystal compound is polymerizable or cross-linkable, the fixation of the alignment state is performed by subjecting the liquid crystal compound aligned as described above to polymerization treatment or cross-linking treatment.

Any appropriate liquid crystal polymer and/or liquid crystal monomer is used as the above-mentioned liquid crystal compound. The liquid crystal polymers and the liquid crystal monomers may each be used alone or in combination thereof. Specific examples of the liquid crystal compound and a method of producing the liquid crystal alignment fixed layer are described in, for example, JP 2006-163343 A, JP 2006-178389 A, and WO 2018/123551 A1, the descriptions of which are incorporated herein by reference.

The thickness of the second λ/4 member including the liquid crystal alignment fixed layer is, for example, from 1 µm to 10 µm, preferably from 1 µm to 8 µm, more preferably from 1 µm to 6 µm, still more preferably from 1 µm to 4 µm.

The thickness direction retardation Rth(550) of the above-mentioned positive C-plate is preferably from -50 nm to - 300 nm, more preferably from -70 nm to -250 nm, still more preferably from -90 nm to -200 nm, particularly preferably from -100 nm to -180 nm. The equation "nx=ny" as used herein encompasses not only a case in which the nx and the ny are strictly equal to each other but also a case in which the nx and the ny are substantially equal to each other. The in-plane retardation Re(550) of the positive C-plate is, for example, less than 10 nm.

The positive C-plate may be formed of any appropriate material. However, the positive C-plate preferably includes a film containing a liquid crystal material fixed in homeotropic alignment. The liquid crystal material (liquid crystal compound) that can be homeotropically aligned may be a liquid crystal monomer or a liquid crystal polymer. Such liquid crystal compound and a method of forming the positive C-plate are specifically, for example, a liquid crystal compound and a method of forming the retardation layer described in paragraphs [0020] to [0028] of JP 2002-333642 A. In this case, the thickness of the positive C-plate is preferably from 0.5 µm to 5 µm.

The second λ/4 member **22a** and the another retardation layer **22b** are laminated via an adhesion layer **50.** The second retardation member **22** includes the second λ/4 member **22a,** the adhesion layer **50,** and the another retardation layer **22b,** and the second λ/4 member **22a** and the another retardation layer **22b** are arranged in direct contact with both the respective sides of the adhesion layer **50.** In other words, the first retardation layer and the second retardation layer are arranged in direct contact with both the respective sides of the adhesion layer **50.**

The refractive index n₀ of the adhesion layer **50** at a wavelength of 550 nm, and the refractive indices n₁ and n₂ of the first retardation layer and the second retardation layer, which are arranged in direct contact with both the respective sides of the adhesion layer **50,** at a wavelength of 550 nm preferably satisfy relationships represented by the following formulae (1) and (2). In the following formula (1), the equation "n₁=n₀" encompasses not only a case in which the n₁ and the n₀ are completely equal to each other but also a case in which the n₁ and the n₀ are substantially equal to each other. Accordingly, there may occur a case in which the n₀ is smaller than the n₁ to the extent that the effects of the present invention are not impaired. In addition, the equation "n₀=n₂" encompasses not only a case in which the n₀ and the n₂ are completely equal to each other but also a case in which the n₀ and the n₂ are substantially equal to each other. Accordingly, there may occur a case in which the n₂ is smaller than the n₀ to the extent that the effects of the present invention are not impaired. ${n}_{1} \leq {n}_{0} \leq {n}_{2}$ ${n}_{2} - {n}_{1} < 0.13$

When such relationships are satisfied, a display system extremely excellent in viewability can be achieved. Specifically, interfacial reflection due to a difference in refractive index between the layers in the lens unit is suppressed, and hence a phenomenon called a ghost in which an image is seen double can be suppressed. The first laminate portion may be greatly involved in the viewability of the display system because in the display system, light may pass through the first laminate portion three times. A state in which the second retardation member in the first laminate portion satisfies such relationships can greatly contribute to an improvement in viewability of the display system. In this embodiment, attention is paid to the refractive indices at a wavelength of 550 nm at which visibility is high (e.g., a human eye easily recognizes light).

Although the refractive indices of the retardation layers for forming the retardation member at a wavelength of 550 nm vary depending on, for example, the materials for forming the retardation layers, the refractive indices are each typically more than 1.40 and less than 1.70. The refractive indices are each represented by, for example, the following formula (3). As represented by the formula (1), the refractive index n₂ of the second retardation layer, which may have a refractive index larger that of the first retardation layer, at a wavelength of 550 nm may satisfy the following formula (3)'. $1.40 < {n}_{2} < 1.70$ $1.50 < {n}_{2} < 1.70$

In one embodiment, the first retardation layer and the second retardation layer arranged in direct contact with both the respective sides of the adhesion layer **50** are different from each other in refractive index at a wavelength of 550 nm. In this case, a difference (n₂-n₁) between the refractive index n₂ of the second retardation layer at a wavelength of 550 nm and the refractive index n₁ of the first retardation layer at a wavelength of 550 nm is more than 0, and may be 0.01 or more, may be 0.02 or more, or may be 0.03 or more. For example, when the first retardation layer corresponds to the second λ/4 member **22a** including a resin film, and the second retardation layer corresponds to a positive C-plate containing a liquid crystal material, the difference (n₂-n₁) may be large. In another embodiment, the first retardation layer and the second retardation layer arranged in direct contact with both the respective sides of the adhesion layer **50** are substantially identical to each other in refractive index at a wavelength of 550 nm. In this case, the difference (n₂-n₁) between the refractive index n₂ of the second retardation layer at a wavelength of 550 nm and the refractive index n₁ of the first retardation layer at a wavelength of 550 nm is substantially 0.

The refractive index n₀ of the adhesion layer **50** in the second retardation member **22** is, for example, 1.40 or more, and may be 1.45 or more. Meanwhile, the refractive index n₀ of the adhesion layer **50** is, for example, 1.65 or less, and may be 1.60 or less. The adhesion layer **50** may be typically formed of an adhesive or a pressure-sensitive adhesive.

For example, an adhesive that may satisfy the formula (1) is selected as the adhesive for forming the adhesion layer **50.** In one embodiment, a curable adhesive is used as the adhesive for forming the adhesion layer **50**. In this case, the adhesion layer (adhesive layer) **50** may be a resin-cured layer. A UV-curable adhesive is preferably used as the curable adhesive. The above-mentioned UV-curable adhesive contains, as a curable monomer, a curable monomer, such as a compound having a (meth)acryloyl group or a compound having a vinyl group. Of those, a compound having a (meth)acryloyl group is preferably used. The term "(meth)acryloyl group" as used herein refers to an acryloyl group and/or a methacryloyl group. The formula (1) may be satisfied by, for example, appropriately selecting the curable monomer.

The thickness of the adhesive layer **50** is preferably 10 µm or less, more preferably 5 µm or less, still more preferably 3 µm or less. With such thickness, the layer can be excellent in, for example, smoothness, and hence can contribute to an improvement in viewability of the display system. Meanwhile, the thickness of the adhesive layer **50** is preferably 0.5 µm or more.

For example, a pressure-sensitive adhesive that may satisfy the formula (1) is selected as the pressure-sensitive adhesive for forming the adhesion layer **50**. Specific examples of the pressure-sensitive adhesive include an acrylic pressure-sensitive adhesive, a rubber-based pressure-sensitive adhesive, a silicone-based pressure-sensitive adhesive, a polyester-based pressure-sensitive adhesive, a urethane-based pressure-sensitive adhesive, an epoxy-based pressure-sensitive adhesive, and a polyether-based pressure-sensitive adhesive. A pressure-sensitive adhesive having desired characteristics in accordance with purposes may be prepared by adjusting, for example, the kinds, number, combination, and blending ratios of monomers for forming the base resin of the pressure-sensitive adhesive, and the blending amount of a cross-linking agent, a reaction temperature, and a reaction time. The base resins of the pressure-sensitive adhesive may be used alone or in combination thereof. An acrylic resin is preferably used as the base resin.

The thickness of the adhesion layer (pressure-sensitive adhesive layer) formed of the pressure-sensitive adhesive may be set to any appropriate thickness. The thickness of the pressure-sensitive adhesive layer is preferably 20 µm or less, and may be 15 µm or less, or may be 10 µm or less. With such thickness, the layer can be excellent in, for example, smoothness, and hence can contribute to an improvement in viewability of the display system.

The above-mentioned first protective member typically includes a substrate. The thickness of the substrate is preferably from 5 µm to 80 µm, more preferably from 10 µm to 50 µm, still more preferably from 15 µm to 40 µm. The substrate may include any appropriate film. Examples of a material serving as a main component for the film for forming the substrate include a cellulose-based resin such as triacetyl cellulose (TAC), a polyester-based resin, a polyvinyl alcohol-based resin, a polycarbonate-based resin, a polyamide-based resin, a polyimide-based resin, a polyether sulfone-based resin, a polysulfone-based resin, a polystyrene-based resin, a cycloolefin-based resin such as polynorbornene, a polyolefin-based resin, a (meth)acrylic resin, and an acetate-based resin. The term "(meth)acrylic" as used herein refers to acrylic and/or methacrylic. In one embodiment, the substrate preferably includes a (meth)acrylic resin. When the (meth)acrylic resin is adopted, a substrate excellent in smoothness can be formed by extrusion molding. In addition, a protective member excellent in smoothness can be obtained.

The first protective member preferably includes the substrate and a surface-treated layer formed on the substrate. The first protective member including the surface-treated layer may be arranged so that the surface-treated layer may be positioned on a front side. Specifically, the surface-treated layer may be positioned on the outermost surface of the first laminate portion. The surface-treated layer may have any appropriate function. The surface-treated layer preferably has an antireflection function from the viewpoint of, for example, improving the viewability. The thickness of the surface-treated layer is preferably from 0.5 µm to 10 µm, more preferably from 1 µm to 7 µm, still more preferably from 2 µm to 5 µm.

The second laminate portion **200** includes: the reflection-type polarizing member **14;** and an adhesion layer (e.g., a pressure-sensitive adhesive layer) arranged between the reflection-type polarizing member **14** and the second lens portion **24.** The second laminate portion **200** further includes an absorption-type polarizing member **28** arranged between the reflection-type polarizing member **14** and the second lens portion **24** from the viewpoint of, for example, improving the viewability. The absorption-type polarizing member **28** is laminated on the front side of the reflection-type polarizing member **14** via an adhesion layer (e.g., a pressure-sensitive adhesive layer) **44.** The reflection axis of the reflection-type polarizing member **14** and the absorption axis of the absorption-type polarizing member **28** may be arranged substantially parallel to each other, and the transmission axis of the reflection-type polarizing member **14** and the transmission axis of the absorption-type polarizing member **28** may be arranged substantially parallel to each other. The reflection-type polarizing member **14** and the absorption-type polarizing member **28** are fixed to each other through lamination of the members via the adhesion layer, and hence a shift in the axial arrangement of the reflection axis of the member **14** and the absorption axis of the member **28** (the transmission axis of the member **14** and the transmission axis of the member **28)** can be prevented. In addition, an adverse effect due to an air layer that may be formed between the reflection-type polarizing member **14** and the absorption-type polarizing member **28** can be suppressed.

The second laminate portion **200** further includes a second protective member **32** arranged on the back side of the reflection-type polarizing member **14.** The second protective member **32** is laminated on the reflection-type polarizing member **14** via an adhesion layer (e.g., a pressure-sensitive adhesive layer) **43.** The second protective member **32** may be positioned on the outermost surface of the second laminate portion **200.** The first protective member **31** and the second protective member **32** are arranged so as to face each other across a space. The second protective member may include a substrate as in the above-mentioned first protective member. In addition, the second protective member preferably includes the substrate and a surface-treated layer to be formed on the substrate. In this case, the surface-treated layer may be positioned on the outermost surface of the second laminate portion. For the details of the substrate and the surface-treated layer, the same descriptions as those in the above-mentioned first protective member may be applied.

As illustrated in FIG. **2****,** the second laminate portion **200** may further include a third retardation member **30** arranged between the absorption-type polarizing member **28** and the second lens portion **24.** The third retardation member **30** is laminated on the absorption-type polarizing member **28** via an adhesion layer (e.g., a pressure-sensitive adhesive layer) **45.** In addition, the third retardation member **30** is laminated on the second lens portion **24** via an adhesion layer (e.g., a pressure-sensitive adhesive layer) **46,** and the second laminate portion **200** is arranged integrally with the second lens portion **24.** The third retardation member **30** includes, for example, a third λ/4 member. An angle formed by the absorption axis of the absorption-type polarizing member **28** and the slow axis of the third λ/4 member in the third retardation member **30** is, for example, from 40° to 50°, may be from 42° to 48°, or may be about 45°. When such member is arranged, for example, the reflection of ambient light from a second lens portion **24** side can be prevented. When the third retardation member is free of any member other than the third λ/4 member, the third retardation member may correspond to the third λ/4 member.

The above-mentioned reflection-type polarizing member can transmit polarized light (typically, linearly polarized light) parallel to its transmission axis while maintaining the polarization state of the light, and can reflect light in any other polarization state. The reflection-type polarizing member typically includes a film having a multilayer structure (sometimes referred to as "reflection-type polarizing film"). In this case, the thickness of the reflection-type polarizing member is, for example, from 10 µm to 150 µm, preferably from 20 µm to 100 µm, more preferably from 30 µm to 60 µm.

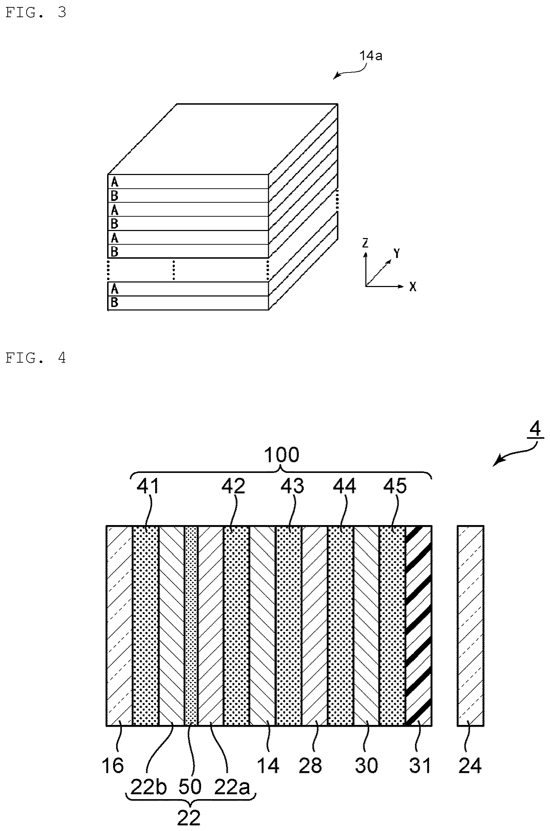

FIG. **3** is a schematic perspective view for illustrating an example of the multilayer structure in the reflection-type polarizing film. A multilayer structure **14a** alternately includes a layer A having birefringence and a layer B substantially free of birefringence. The total number of the layers for forming the multilayer structure may be from 50 to 1,000. For example, the refractive index nx of the A layer in an x-axis direction is larger than the refractive index ny thereof in a y-axis direction, the refractive index nx of the B layer in the x-axis direction and the refractive index ny thereof in the y-axis direction are substantially identical to each other, and a difference in refractive index between the A layer and the B layer is large in the x-axis direction, and is substantially zero in the y-axis direction. As a result, the x-axis direction may serve as a reflection axis, and the y-axis direction may serve as a transmission axis. The difference in refractive index between the A layer and the B layer in the x-axis direction is preferably from 0.2 to 0.3.

The above-mentioned A layer typically includes a material that expresses birefringence by being stretched. Examples of such material include a naphthalene dicarboxylic acid polyester (e.g., polyethylene naphthalate), polycarbonate, and an acrylic resin (e.g., polymethyl methacrylate). The above-mentioned B layer typically includes a material that is substantially free from expressing birefringence even when stretched. Such material is, for example, a copolyester of naphthalene dicarboxylic acid and terephthalic acid. The above-mentioned multilayer structure may be formed by combining coextrusion and stretching. For example, the material for forming the A layer and the material for forming the B layer are extruded, and are then multilayered (with, for example, a multiplier). Next, the resultant multilayer laminate is stretched. The x-axis direction in the illustrated example may correspond to the stretching direction.

A commercial product of the reflection-type polarizing film is, for example, a product available under the product name "DBEF" or "APF" from 3M Company, or a product available under the product name "APCF" from Nitto Denko Corporation.

The cross transmittance (Tc) of the reflection-type polarizing member (reflection-type polarizing film) may be, for example, from 0.01% to 3%. The single layer transmittance (Ts) of the reflection-type polarizing member (reflection-type polarizing film) is, for example, from 43% to 49%, preferably from 45% to 47%. The polarization degree (P) of the reflection-type polarizing member (reflection-type polarizing film) may be, for example, from 92% to 99.99%.

The above-mentioned cross transmittance, single layer transmittance, and polarization degree may each be measured with, for example, a UV-visible spectrophotometer. The polarization degree P may be determined as follows: the single layer transmittance Ts, the parallel transmittance Tp, and the cross transmittance Tc are measured with the UV-visible spectrophotometer; and the degree is determined from the Tp and Tc thus obtained by using the following equation. The Ts, the Tp, and the Tc are each a Y value measured with the two-degree field of view (C light source) of JIS Z 8701 and subjected to visibility correction. $Polarization degree P \left(%\right) = {\left\{\left(Tp-Tc\right)/\left(Tp+Tc\right)\right\}}^{1 / 2} \times 100$

The above-mentioned absorption-type polarizing member may typically include a resin film containing a dichroic substance (sometimes referred to as "absorption-type polarizer"). The thickness of the absorption-type polarizer is, for example, 1 µm or more and 20 µm or less, and may be 2 µm or more and 15 µm or less, may be 12 µm or less, may be 10 µm or less, may be 8 µm or less, or may be 5 µm or less.

The above-mentioned absorption-type polarizer may be produced from a single-layer resin film, or may be produced by using a laminate of two or more layers.

When the absorption-type polarizer is produced from the single-layer resin film, the absorption-type polarizer may be obtained by, for example, subjecting a hydrophilic polymer film, such as a polyvinyl alcohol (PVA)-based film, a partially formalized PVA-based film, or an ethylene-vinyl acetate copolymer-based partially saponified film, to dyeing treatment with a dichroic substance, such as iodine or a dichroic dye, stretching treatment, or the like. Of such polarizers, an absorption-type polarizer obtained by dyeing a PVA-based film with iodine and uniaxially stretching the dyed film is preferred.

The above-mentioned dyeing with iodine is performed by, for example, immersing the PVA-based film in an aqueous solution of iodine. The stretching ratio of the above-mentioned uniaxial stretching is preferably from 3 times to 7 times. The stretching may be performed after the dyeing treatment, or may be performed while the dyeing is performed. Alternatively, the dyeing may be performed after the stretching. The PVA-based film is subjected to swelling treatment, cross-linking treatment, washing treatment, drying treatment, or the like as required.

When the absorption-type polarizer is produced by using the above-mentioned laminate of two or more layers, the laminate is, for example, a laminate of a resin substrate and a PVA-based resin layer (PVA-based resin film) laminated on the resin substrate or a laminate of a resin substrate and a PVA-based resin layer formed on the resin substrate through application. The absorption-type polarizer obtained by using the laminate of the resin substrate and the PVA-based resin layer formed on the resin substrate through application may be produced, for example, by: applying a PVA-based resin solution to the resin substrate; drying the solution to form the PVA-based resin layer on the resin substrate, to thereby provide the laminate of the resin substrate and the PVA-based resin layer; and stretching and dyeing the laminate to turn the PVA-based resin layer into the absorption-type polarizer. In this embodiment, a polyvinyl alcohol-based resin layer containing a halide and a polyvinyl alcohol-based resin is preferably formed on one side of the resin substrate. The stretching typically includes stretching the laminate under a state in which the laminate is immersed in an aqueous solution of boric acid. Further, the stretching may further include in-air stretching of the laminate at high temperature (e.g., 95°C or more) before the stretching in the aqueous solution of boric acid as required. In addition, in this embodiment, the laminate is preferably subjected to drying shrinkage treatment, which includes heating the laminate, while conveying the laminate in its lengthwise direction, to shrink the laminate by 2% or more in its widthwise direction. The production method of this embodiment typically includes subjecting the laminate to in-air auxiliary stretching treatment, dyeing treatment, underwater stretching treatment, and drying shrinkage treatment in the stated order. When the auxiliary stretching is introduced, even in the case where PVA is applied onto a thermoplastic resin, the crystallinity of the PVA can be improved, and hence high optical characteristics can be achieved. In addition, when the alignment property of the PVA is improved in advance simultaneously with the crystallinity improvement, problems, such as reductions in alignment properties of the molecules of the PVA and the dissolution thereof, can be prevented at the time of the immersion of the laminate in water in the subsequent dyeing step or stretching step, and hence high optical characteristics can be achieved. Further, in the case where the PVA-based resin layer is immersed in a liquid, the disturbance of the alignment of the molecules of polyvinyl alcohol and reductions in alignment properties thereof can be suppressed as compared to those in the case where the PVA-based resin layer is free of any halide. Thus, the optical characteristics of the absorption-type polarizer to be obtained through treatment steps performed by immersing the laminate in a liquid, such as the dyeing treatment and the underwater stretching treatment, can be improved. Further, the optical characteristics can be improved by shrinking the laminate in its widthwise direction through the drying shrinkage treatment. The resultant laminate of the resin substrate and the absorption-type polarizer may be used as it is (that is, the resin substrate may be used as a protective layer for the absorption-type polarizer), or may be used by laminating any appropriate protective layer in accordance with purposes on the peeled surface on which the resin substrate has been peeled from the laminate of the resin substrate and the absorption-type polarizer, or on a surface on the side opposite to the peeled surface. The details of such method of producing the absorption-type polarizer are described in, for example, JP 2012-73580 A and JP 6470455 B1, the descriptions of which are incorporated herein by reference in their entirety.

The cross transmittance (Tc) of the absorption-type polarizing member (absorption-type polarizer) is preferably 0.5% or less, more preferably 0.1% or less, still more preferably 0.05% or less. The single layer transmittance (Ts) of the absorption-type polarizing member (absorption-type polarizer) is, for example, from 41.0% to 45.0%, preferably 42.0% or more. The polarization degree (P) of the absorption-type polarizing member (absorption-type polarizer) is, for example, from 99.0% to 99.997%, preferably 99.9% or more.

The in-plane retardation Re(550) of the above-mentioned third A/4 member is, for example, from 100 nm to 190 nm, and may be from 110 nm to 180 nm, may be from 130 nm to 160 nm, or may be from 135 nm to 155 nm. The third λ/4 member preferably shows such a reverse wavelength dispersion characteristic that its retardation value increases with an increase in wavelength of measurement light. The ratio "Re(450)/Re(550)" of the third λ/4 member is, for example, 0.75 or more and less than 1, and may be 0.8 or more and 0.95 or less. The refractive index characteristic of the third λ/4 member preferably shows the relationship of nx>ny ≥nz. The Nz coefficient of the third A/4 member is preferably from 0.9 to 3, more preferably from 0.9 to 2.5, still more preferably from 0.9 to 1.5, particularly preferably from 0.9 to 1.3.

The third λ/4 member is formed of any appropriate material that may satisfy the above-mentioned characteristics. The third λ/4 member may be, for example, a stretched film of a resin film or an alignment fixed layer of a liquid crystal compound. The same description as that of the above-mentioned second λ/4 member may be applied to the third λ/4 member including the stretched film of the resin film or the alignment fixed layer of the liquid crystal compound. The second λ/4 member and the third λ/4 member may be members having the same configuration (e.g., a formation material, a thickness, or optical characteristics), or may be members having different configurations.

FIG. **4** is a schematic sectional view for illustrating another example of the details of the lens unit of the display system illustrated in FIG. **1****.** Specifically, FIG. **4** is an illustration of a first lens portion, a second lens portion, and members to be arranged therebetween. The lens unit **4** includes the first lens portion **16,** the first laminate portion **100** arranged adjacent to the first lens portion **16,** and the second lens portion **24.** The first laminate portion **100** and the second lens portion **24** are arranged so as to be spaced apart from each other.

The first laminate portion **100** includes: the second retardation member **22** having a laminated structure of the second λ/4 member **22a** and the another retardation layer **22b;** the reflection-type polarizing member **14;** the absorption-type polarizing member **28;** the third retardation member **30;** and the first protective member **31.** In addition, the portion includes the adhesion layers (e.g., pressure-sensitive adhesive layers) **41** to **45** that integrate the respective members. In the example illustrated in FIG. **4****,** unlike the example illustrated in FIG. **2****,** the member arranged between the first lens portion **16** and the second lens portion **24** is arranged integrally with the first lens portion **16.** In addition, only the first protective member **31** is arranged as a protective member in contact with a space formed between the first lens portion **16** and the second lens portion **24.**

### Examples

The present invention is specifically described below by way of Examples. However, the present invention is not limited to these Examples. A thickness, a retardation value, and a refractive index are values measured by the following measurement methods.

### <Thickness>

A thickness of 10 µm or less was measured with a scanning electron microscope (manufactured by JEOL Ltd., product name: "JSM-7100F"). A thickness of more than 10 µm was measured with a digital micrometer (manufactured by Anritsu Corporation, product name: "KC-351C").

### <Retardation Value>

Retardation values at respective wavelengths at 23°C were measured with a Mueller matrix polarimeter (manufactured by Axometrics, Inc., product name: "AxoScan").

### <Refractive Index>

The in-plane refractive index and thickness direction refractive index of a film or a layer serving as a measurement object were measured with a prism coupler (MODEL 2010/M manufactured by Metricon Corporation), and the refractive index (average refractive index) thereof was determined by calculating the average of these values. A measurement temperature was set to 23°C, and a measurement wavelength was set to 407 nm, 594 nm, or 782 nm. The refractive index thereof at 550 nm was calculated from the resultant measured values and Cauchy's dispersion formula.

### [Example 1]

### (Production of A/4 Member)

Polymerization was performed with a batch polymerization apparatus formed of two vertical reactors each including a stirring blade and a reflux condenser controlled to 100°C. 29.60 Parts by weight (0.046 mol) of bis[9-(2-phenoxycarbonylethyl)fluoren-9-yl]methane, 29.21 parts by weight (0.200 mol) of isosorbide (ISB), 42.28 parts by weight (0.139 mol) of spiroglycol (SPG), 63.77 parts by weight (0.298 mol) of diphenyl carbonate (DPC), and 1.19×10⁻² part by weight (6.78×10⁻⁵ mol) of calcium acetate monohydrate serving as a catalyst were loaded into the batch polymerization apparatus. After the inside of the reactor had been purged with nitrogen under reduced pressure, the inside was warmed with a heat medium, and stirring was started at the time point when the internal temperature became 100°C. 40 Minutes after the start of the temperature increase, the internal temperature was caused to reach 220°C, and such control that the temperature was held was performed. At the same time, a pressure reduction was started, and a pressure in the reactor was set to 13.3 kPa in 90 minutes after the temperature had reached 220°C. Phenol vapor produced as a by-product along with a polymerization reaction was introduced into the reflux condenser at 100°C, a monomer component present in a trace amount in the phenol vapor was returned to the reactor, and the phenol vapor that did not condense was introduced into a condenser at 45°C and recovered. Nitrogen was introduced into the first reactor to return the pressure therein to the atmospheric pressure once, and then an oligomerized reaction liquid in the first reactor was transferred to the second reactor. Next, a temperature increase and a pressure reduction in the second reactor were started, and the internal temperature and the pressure were set to 240°C and 0.2 kPa, respectively in 50 minutes. After that, the polymerization was advanced until predetermined stirring power was obtained. At the time point when the predetermined power was achieved, nitrogen was introduced into the reactor to return the pressure, and the produced polyester carbonate-based resin was extruded into water, followed by the cutting of a strand. Thus, a pellet was obtained.

The resultant polyester carbonate-based resin (pellet) was dried in a vacuum at 80°C for 5 hours, and then an elongate resin film having a thickness of 135 µm was produced from the resin with a film-forming apparatus including a single-screw extruder (manufactured by Toshiba Machine Co., Ltd., cylinder set temperature: 250°C), a T-die (width: 200 mm, set temperature: 250°C), a chill roll (set temperature: from 120°C to 130°C), and a winding machine. The resultant elongate resin film was stretched in its widthwise direction at a stretching temperature of 143°C and a stretching ratio of 2.8 times to provide a stretched film having a thickness of 47 µm. The resultant stretched film had an Re(550) of 143 nm, a ratio "Re(450)/Re(550)" of 0.86, and an Nz coefficient of 1.2. In addition, the resultant stretched film had a refractive index of 1.53.

### (Production of Positive C-plate)

20 Parts by weight of a side chain-type liquid crystal polymer represented by the following chemical formula (1) (numbers 65 and 35 in the formula each represent the mole percent of a monomer unit, and the polymer is represented in a block polymer form for convenience: weight-average molecular weight: 5,000), 80 parts by weight of a polymerizable liquid crystal showing a nematic liquid crystal phase (manufactured by BASF SE: product name: Paliocolor LC242), and 5 parts by weight of a photopolymerization initiator (manufactured by Ciba Specialty Chemicals: product name: IRGACURE 907) were dissolved in 200 parts by weight of cyclopentanone to prepare a liquid crystal application liquid. Then, the application liquid was applied to a PET substrate subjected to vertical alignment treatment with a bar coater, and was then dried by heating at 80°C for 4 minutes so that the liquid crystal was aligned. UV light was applied to the liquid crystal layer to cure the liquid crystal layer. Thus, a positive C-plate having a thickness of 4 µm, an Rth(550) of - 100 nm, and a refractive index of 1.62 was formed on the substrate.

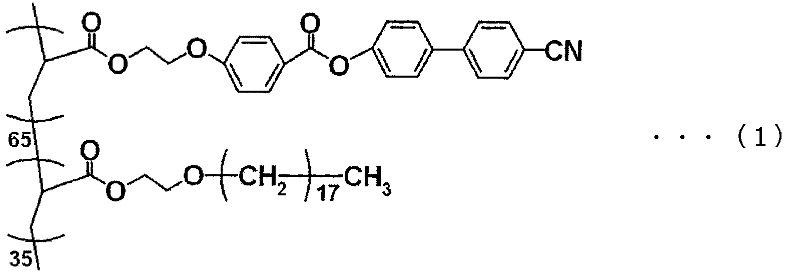

### (Preparation of Adhesive 1)

20 Parts by weight of acryloylmorpholine (manufactured by Kohjin Co., Ltd., "ACMO (trademark)"), 10 parts by weight of an unsaturated fatty acid hydroxyalkyl ester-modified ε-caprolactone (manufactured by Daicel Corporation, product name: "PLACCEL FA-1DDM"), 60 parts by weight of a fluorene-based acrylate (manufactured by Osaka Gas Chemicals Co., Ltd., product name: "OGSOL EA-F5710"), 5 parts by weight of an acrylic polymer (manufactured by Toagosei Co., Ltd., "ARFON UP-1190"), 3 parts by weight of a photopolymerization initiator (manufactured by IGM Resins B.V., product name: "Omnirad 907"), and 2 parts by weight of another photopolymerization initiator (manufactured by Nippon Kayaku Co., Ltd., product name: "KAYACURE DETX-S") were mixed to prepare an adhesive 1.

UV light at an integrated light quantity of 300 mJ/cm² was applied from a high-pressure mercury lamp to the resultant adhesive 1 to cure the adhesive. The resultant adhesive layer having a thickness of 1 µm had a refractive index of 1.57.

### (Production of Retardation Member)

A retardation member was obtained by bonding the above-mentioned positive C-plate to the above-mentioned λ/4 member (stretched film) via the adhesive 1 (thickness after photocuring: 1 µm).

### [Comparative Example 1]

A retardation member was obtained in the same manner as in Example 1 except that the following adhesive 2 (thickness after photocuring: 1 µm) was used instead of the adhesive 1 at the time of the lamination of the above-mentioned λ/4 member (stretched film) and the above-mentioned positive C-plate.

### (Preparation of Adhesive 2)

20 Parts by weight of acryloylmorpholine (manufactured by Kohjin Co., Ltd., "ACMO (trademark)"), 50 parts by weight of an unsaturated fatty acid hydroxyalkyl ester-modified ε-caprolactone (manufactured by Daicel Corporation, product name: "PLACCEL FA-1DDM"), 10 parts by weight of polyethylene glycol diacrylate (manufactured by Kyoeisha Chemical Co., Ltd., product name: "Light Acrylate 9EG-A"), 15 parts by weight of an acrylic polymer (manufactured by Toagosei Co., Ltd., "ARFON UP-1190"), 3 parts by weight of a photopolymerization initiator (manufactured by IGM Resins B.V., product name: "Omnirad 907"), and 2 parts by weight of another photopolymerization initiator (manufactured by Nippon Kayaku Co., Ltd., product name: "KAYACURE DETX-S") were mixed to prepare an adhesive 2.

UV light at an integrated light quantity of 300 mJ/cm² was applied from a high-pressure mercury lamp to the resultant adhesive 2 to cure the adhesive. The resultant adhesive layer having a thickness of 1 µm had a refractive index of 1.51.

### [Comparative Example 2]

A retardation member was obtained in the same manner as in Example 1 except that the above-mentioned λ/4 member (stretched film) and the above-mentioned positive C-plate were laminated via the following pressure-sensitive adhesive layer instead of the use of the adhesive 1.

### (Formation of Pressure-sensitive Adhesive Layer)

A monomer mixture containing 92 parts by weight of butyl acrylate, 2.9 parts by weight of acrylic acid, 0.1 part by weight of 2-hydroxyethyl acrylate, and 5 parts by weight of N-acryloylmorpholine was loaded into a four-necked flask including a stirring blade, a temperature gauge, a nitrogen gas introduction tube, and a condenser. Further, 0.1 part by weight of 2,2'-azobisisobutyronitrile serving as a polymerization initiator was loaded into 100 parts by weight of the monomer mixture together with 200 parts by weight of ethyl acetate, and the inside of the flask was purged with nitrogen by introducing a nitrogen gas under gentle stirring. After that, a polymerization reaction was performed for 8 hours while a liquid temperature in the flask was kept at about 55°C. Thus, a solution of an acrylic polymer having a weight-average molecular weight (Mw) of 1,780,000 was prepared.

The resultant acrylic polymer solution was applied to a substrate film, and was dried to form a pressure-sensitive adhesive layer having a thickness of 5 µm and a refractive index of 1.47 on the substrate film.

### <Evaluation: Transmittance Measurement>

The transmittances of the retardation members obtained in Example and Comparative Examples were measured. A UV-visible spectrophotometer (manufactured by JASCO Corporation, V-7100) was used as a measuring apparatus, and the transmittance spectrum of each of the members was measured, followed by the reading of the transmittance thereof at a wavelength of 550 nm.

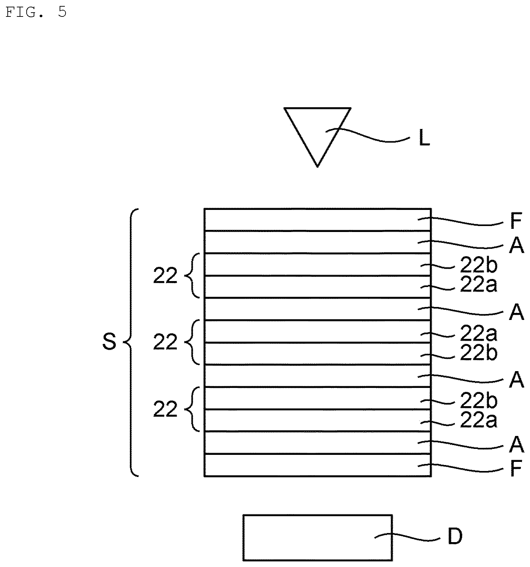

In each of Example and Comparative Examples, three retardation members were prepared. Those members were superimposed on each other with the following pressure-sensitive adhesive layers **A** for lamination to form a laminate. As illustrated in FIG. **5****,** a 40-micrometer thick acrylic film **F** having a lactone ring structure was bonded to each of both the sides of the resultant laminate with the following pressure-sensitive adhesive layer **A** for lamination to provide a measurement sample **S.** As illustrated in FIG. **5****,** when the three retardation members **22** were superimposed on each other, the retardation member **22** positioned closest to the light source **L** of the measuring apparatus was arranged so that its λ/4 member **22a** was positioned on the detector **D** side of the measuring apparatus. The retardation member **22** positioned in the middle of the laminate was arranged so that its λ/4 member **22a** was positioned on the light source L side of the measuring apparatus. The retardation member **22** positioned closest to the detector **D** of the measuring apparatus was arranged so that its λ/4 member **22a** was positioned on the detector **D** side of the measuring apparatus. For ease of viewing of the figure, in FIG. **5****,** the adhesion layer (adhesive layer or pressure-sensitive adhesive layer) **50** in each of the retardation members **22** is omitted.

The results of the measurement are shown in Table 1. The row "Total of differences" in Table 1 shows the total of a difference between the n₁ and n₀, and a difference between the n₂ and n₀. In addition, the transmittance (92.0%) of Reference Example in Table 1 represents the transmittance of a measurement sample obtained by: preparing one retardation member of Comparative Example 1; and bonding the 40-micrometer thick acrylic film **F** having a lactone ring structure to each of both the sides of the retardation member with the following pressure-sensitive adhesive layer **A** for lamination.

### (Formation of Pressure-sensitive Adhesive Layer A for Lamination)

A monomer mixture containing 94.9 parts by weight of butyl acrylate, 5 parts by weight of acrylic acid, and 0.1 part by weight of 2-hydroxyethyl acrylate was loaded into a four-necked flask including a stirring blade, a temperature gauge, a nitrogen gas introduction tube, and a condenser. Further, 0.3 part by weight of dibenzoyl peroxide serving as a polymerization initiator was loaded into 100 parts by weight of the monomer mixture together with ethyl acetate, and the inside of the flask was purged with nitrogen by introducing a nitrogen gas under gentle stirring. After that, a polymerization reaction was performed for 7 hours while a liquid temperature in the flask was kept at 60°C. Next, ethyl acetate was added to the resultant reaction liquid to adjust its solid content concentration to 30 wt%. Thus, a solution of an acrylic polymer having a weight-average molecular weight (Mw) of 2,200,000 was prepared.

100 Parts by weight of the solid content of the resultant acrylic polymer solution was blended with 0.6 part by weight of a trimethylolpropane/tolylene diisocyanate adduct (product name: CORONATE L, manufactured by Tosoh Corporation) and 0.075 part by weight of a silane coupling agent (product name: KBM-403, manufactured by Shin-Etsu Chemical Co., Ltd.) to prepare an acrylic pressure-sensitive adhesive.

The resultant acrylic pressure-sensitive adhesive was applied to a substrate film, and was dried to form a pressure-sensitive adhesive layer **A** for lamination having a thickness of 15 µm on the substrate film.

**Table 1**

| | | Example 1 | Comparative Example 1 | Comparative Example 2 | Reference Example |
|---|---|---|---|---|---|
| Refractive index | n₁ | 1.53 | 1.53 | 1.53 | 1.53 |
| | n₂ | 1.62 | 1.62 | 1.62 | 1.62 |
| | n₀ | 1.57 | 1.51 | 1.47 | 1.51 |
| | Total of differences | 0.09 | 0.13 | 0.20 | 0.13 |
| Transmittance (550 nm) | | 91.6% | 91.4% | 91.4% | 92.0% |
| Difference in transmittance from Reference Example | | -0.4% | -0.6% | -0.6% | - |

In Example, the difference in transmittance from Reference Example is improved by about 30% as compared to Comparative Examples. The transmittance of a retardation member may have a significant impact on the viewability of a display system because an image may be enlarged in its lens unit (e.g., by a convex lens).

The present invention is not limited to the above-mentioned embodiments, and various modifications may be made thereto. For example, the configurations described in the above-mentioned embodiments may each be replaced by substantially the same configuration, a configuration having the same action and effect, or a configuration that can achieve the same object.

### Industrial Applicability

The lens unit according to the embodiment of the present invention may be used in, for example, a display body such as a pair of VR goggles.

### Reference Signs List

**2** display system, **4** lens unit, **12** display element, **14** reflection-type polarizing member, **16** first lens portion, **18** half mirror, **20** first retardation member, **22** second retardation member, **22a** second λ/4 member, **22b** another retardation layer, **24** second lens portion, **28** absorption-type polarizing member, **30** third retardation member, **31** first protective member, **32** second protective member, **41** adhesion layer, **42** adhesion layer, **43** adhesion layer, **44** adhesion layer, **45** adhesion layer, **46** adhesion layer, **50** adhesion layer, **100** first laminate portion, **200** second laminate portion.

## Claims

1. A lens unit to be used in a display system configured to display an image to a user, the lens unit comprising:
a reflection-type polarizing member configured to reflect light, which has been emitted to a front side from a display surface of a display element configured to display the image, and has passed through a polarizing member and a first λ/4 member;
a first lens portion arranged on an optical path between the display element and the reflection-type polarizing member;
a half mirror arranged between the display element and the first lens portion, the half mirror being configured to transmit the light emitted from the display element and to reflect the light reflected by the reflection-type polarizing member toward the reflection-type polarizing member;
a second lens portion arranged on the front side of the reflection-type polarizing member; and
a retardation member arranged on an optical path between the half mirror and the reflection-type polarizing member,
wherein the retardation member includes a first retardation layer, an adhesion layer, and a second retardation layer in the stated order, the first retardation layer or the second retardation layer functions as a second λ/4 member, and a refractive index n₁ of the first retardation layer at a wavelength of 550 nm, a refractive index n₀ of the adhesion layer at a wavelength of 550 nm, and a refractive index n₂ of the second retardation layer at a wavelength of 550 nm satisfy relationships represented by the following formulae (1) and (2). ${n}_{1} \leq {n}_{0} \leq {n}_{2}$ ${n}_{2} - {n}_{1} < 0.13$

2. The lens unit according to claim 1, wherein the refractive index n₂ of the second retardation layer at a wavelength of 550 nm satisfies the following formula (3). $1.40 < {n}_{2} < 1.70$

3. The lens unit according to claim 1, wherein the second λ/4 member satisfies Re(450)<Re(550).

4. The lens unit according to claim 1, wherein the lens unit comprises a laminate portion including the retardation member.

5. The lens unit according to claim 4, wherein the laminate portion includes the reflection-type polarizing member.

6. The lens unit according to claim 5, wherein the laminate portion includes an absorption-type polarizing member arranged between the reflection-type polarizing member and the second lens portion.

7. The lens unit according to claim 5, wherein the laminate portion includes a third λ/4 member arranged between the reflection-type polarizing member and the second lens portion.

8. The lens unit according to claim 4, wherein the laminate portion includes a protective member arranged on a front side of the retardation member.

9. A display body, comprising the lens unit of any one of claims 1 to 8.

10. A display method, comprising the steps of:
passing light representing an image, which has been emitted through a polarizing member and a first λ/4 member, through a half mirror and a first lens portion;
passing the light, which has passed through the half mirror and the first lens portion, through a retardation member;
reflecting the light, which has passed through the retardation member, toward the half mirror with a reflection-type polarizing member;
enabling the light, which has been reflected by the reflection-type polarizing member and the half mirror, to penetrate through the reflection-type polarizing member with the retardation member; and
passing the light, which has penetrated through the reflection-type polarizing member, through a second lens portion,
wherein the retardation member includes a first retardation layer, an adhesion layer, and a second retardation layer in the stated order, the first retardation layer or the second retardation layer functions as a second λ/4 member, and a refractive index n₁ of the first retardation layer at a wavelength of 550 nm, a refractive index n₀ of the adhesion layer at a wavelength of 550 nm, and a refractive index n₂ of the second retardation layer at a wavelength of 550 nm satisfy relationships represented by the following formulae (1) and (2). ${n}_{1} \leq {n}_{0} \leq {n}_{2}$ ${n}_{2} - {n}_{1} < 0.13$
